# EUROPEAN PATENT SPECIFICATION

(11) **EP 3 071 005 B1**
(45) Date of publication and mention of the grant of the patent: **10.07.2019**
(21) Application number: 14875343.7
(22) Date of filing: 21.08.2014
(51) Int. Cl.: H05K 7/20

(54) **SUBRACK AND TERMINAL**
BAUGRUPPENTRÄGER UND ENDGERÄT
TIROIR ET TERMINAL

(30) Priority: 27.12.2013 CN 201320877647 U
(43) Date of publication of application: 21.09.2016
(73) Proprietor: ZTE Corporation, Shenzhen, Guangdong 518057 (CN)
(72) Inventor: GAO, Yibing, Shenzhen Guangdong 518057 (CN); YAO, Dongsheng, Shenzhen Guangdong 518057 (CN); ZHAO, Fei, Shenzhen Guangdong 518057 (CN)
(74) Representative: CMS Cameron McKenna Nabarro Olswang LLP
(86) International application number: PCT/CN2014/084959
(87) International publication number: WO 2015/096499

(56) References cited:
- WO-A1-2010/145069
- CN-A- 101 621 913
- CN-U- 203 691 803
- US-A1- 2009 097 203
- US-A1- 2009 154 098
- US-A1- 2011 011 562
- US-A1- 2013 107 452

## Description

### Technical Field

The present invention relates to the field of communication, especially to a subrack and terminal.

### Background of the Related Art

A related subrack normally comprises a case, a plurality of first main boards arranged at the front of the case and a plurality of second main boards arranged at the rear of the case, for the convenient of heat dissipation of the subrack, a fan is usually mounted in the rear of the subrack and an air inlet is opened at the front of the subrack. However, in this manner of air exhaust, the heat of the first main boards at the front of the subrack is easily brought to the second main boards at the rear of the subrack, which makes the second main boards in the rear of the subrack be in the environment of a high temperature for a long time and causes the fast aging of the second main boards at the rear of the subrack, thereby reducing the reliability of the device.

US 2011/0011562 A1 discloses a front-to-back cooling system that allows cooling of an apparatus containing two orthogonal sets of modules.

### Summary of the Invention

The present invention provides a subrack according to claim land a terminal according to claim 5, to avoid the problem of the second main boards in the rear of the subrack being heated by the first main boards at the front of the subrack. Further improvements and embodiments are provided in the dependent claims.

Accordingly, the subrack comprises a case, and a first main board area configured at a front of the case and a second main board area configured at a rear of the case, and further comprises:
a first air passage, configured within the case, wherein a first air inlet of the first air
   passage is configured in a front wall of the case, and the first air inlet is configured opposite to the first main board area, and a first air outlet of the first air passage is configured in a rear wall of the case;
a second air passage, configured within the case, wherein the second air passage is configured to be isolated from the first air passage, a second air inlet of the second air passage is configured in the front wall of the case and the second air inlet is under the first main board area, and a second air outlet of the second air passage is configured in the rear wall of the case.

Further, a first clapboard is configured between the first main board area and the second air inlet, and the first clapboard is used to isolate the first air inlet from the second air inlet.

Further, the first main board area comprises a plurality of first sub-main boards which are horizontally arranged, each of the first sub-main boards comprises a PCB board, a panel and a tray, a first air hole is configured at a part of the panel which is located on an upside of the PCB board, a second air hole is configured between the PCB board and the tray, both the first air hole and the second air hole are connected to the first air inlet, and the second air hole is connected to an adjacent first sub-main board through an open pore on the tray.

Further, a backboard is configured between the first main board area and the second main board area, an opening connected to the first air passage is configured on the backboard, and the second air passage is configured under the backboard.

Further, the second main board area comprises a plurality of second sub-main boards which are longitudinally arranged, a guide plate is slantly configured between the second main board area and a lower wall of the case, and the guide plate is connected to the plurality of second sub-main boards, to lead air in the second air passage into the plurality of second sub-main boards.

Further, the subrack further comprises:
a first air exhaust device, configured to drive the air entering from the first air inlet into the first air passage to flow through the first main board area and then exhaust from the rear wall of the case, and the first air exhaust device being configured in the rear wall of the case;
a second air exhaust device, configured to drive the air entering from the second air inlet into the second air passage to flow through the second main board area and then exhaust from the rear wall of the case, the second air exhaust device being configured in the rear wall of the case, and the second air exhaust device being configured to be isolated from the first air exhaust device.

Further, the first air exhaust device comprises a first sub-air exhaust device, a second sub-air exhaust device and a third sub-air exhaust device that are configured around the second main board area, the first sub-air exhaust device and the third sub-air exhaust device are respectively configured at the upside and underside of the second main board area, and the first sub-air exhaust device, the second sub-air exhaust device and the third sub-air exhaust device are connected together to form a C-type structure.

Further, the second air exhaust device is configured between the second main board area and the first sub-air exhaust device, and a second clapboard is configured between the first sub-air exhaust device and the second air exhaust device.

The terminal according to the invention comprises the above-mentioned subrack.

The beneficial effect of the above mentioned technical scheme is: achieving independent heat dissipation for the first main board area and the second main board area, and preventing the heat from mutually interfering and accumulating.

### Brief Description of Drawings

FIG. 1 is a schematic diagram of a structure of a subrack of an embodiment of the present invention;
FIG. 2 is a front view of a subrack of an embodiment of the present invention;
FIG. 3 is a rear view of a subrack of an embodiment of the present invention;
FIG. 4 is a schematic diagram of an air flow direction of a first air passage and a second air passage of a subrack of an embodiment of the present invention;
FIG. 5 is a schematic diagram of a structure of a first sub-main board of an embodiment of the present invention.

### Preferred Embodiments of the Invention

The structure and principal of the embodiments of the present invention will be described hereinafter in details in combination with the accompanying drawings. The illustrated embodiments are used to explain the present invention, but do not limit the protection scope of the present invention.

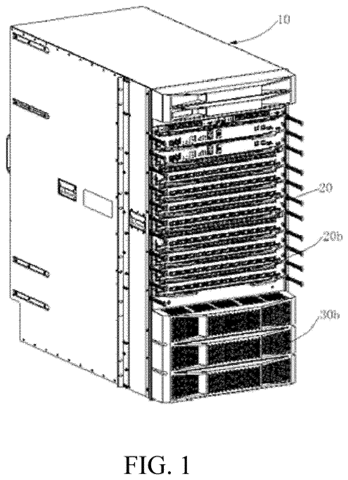

As shown in FIGs. 1- 5, the present embodiment provides a subrack, comprises a case 10, a first main board area 20 configured at a front of the case 10 and a second main board area 30 configured at a rear of the case 10, and further comprises:
the first air passage, is configured within the case 10, a first air inlet 20b of the first air passage is configured in a front wall 11 of the case 10, and the first air inlet 20b is configured opposite to the first main board area 20, and a first air outlet of the first air passage is configured in a rear wall 12 of the case 10;
a second air passage, is configured within the case 10, the second air passage is configured to be isolated from the first air passage, a second air inlet 30b of the second air passage is configured in a front wall 11 of the case 10 and the second air inlet 30b is under the first main board area 20, and a second air outlet of the second air passage is configured in the rear wall 12 of the case 10.

The first air passage configured to cool the first main board area is configured to be isolated from the second air passage configured to cool the second main board area, so as to achieve independent heat dissipation for the first main board area and the second main board area, and prevent the heat from mutually interfering and accumulating; and both the first air passage and the second air passage adopt a manner of entering at the front and going out at the rear, so as to avoid backflow of the hot air.

It should be illustrated that, description of words represented location relationships, such as "upside", "underside", "left", "right", "front", "rear" and so on, related to the present embodiment should be all referred to figures as shown.

In the present embodiment, a first clapboard (not shown in the figures) is configured between the first main board area 20 and the second air inlet, and is used to isolate the first air inlet from the second air inlet.

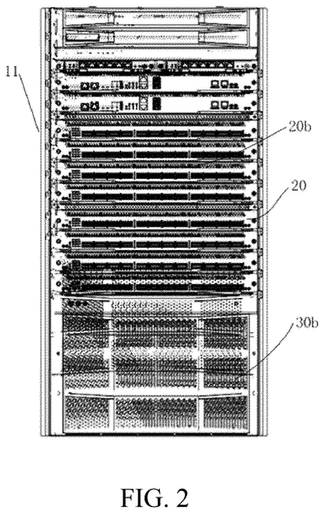

As shown in Fig.1 and Fig.2, in the present embodiment, the first main board area 20 comprises a plurality of first sub-main boards which are horizontally arranged, the first sub-main board itself, which is in the first main board area 20 and near a lower wall of the case 10, can work for insulating the first air inlet from the second air inlet. However, for preventing an air hole in the first sub-main board or an installation gap, etc., to influence the isolated tightness of the first air inlet and the second air inlet, in the present embodiment, the first clapboard is used to isolate the first air inlet and the second air inlet so as to avoid heat accumulating of the first main board area 20 and the second main board area 30.

In the present embodiment, each of the first sub-main boards comprises a PCB board, a panel and a tray, a first air hole 31 is configured at a part of the panel which is located on an upside of the PCB board, a second air hole 32 is configured between the PCB board and the tray, both the first air hole 31 and the second air hole 32 are connected to the first air inlet 20b, and the second air hole 32 is connected to an adjacent first sub-main board through an open pore on the tray.

The air entered from the first air hole 31 is used to cool the corresponding first sub-main board, the air entering from the second air hole 32 is used to through the open pore on the tray cool a underside and adjacent first sub-main board. The tray configures with the open pore and a windshield bar, which leads the air entering from the air hole 32 to enter into the underside and adjacent first sub-main board.

The appended air hole (the second air hole 32) of the first sub-main board can effectively increase the area of incoming air and improve the ability of heat dissipation of the system.

In the present embodiment, a backboard 80 is configured between the first main board area 20 and the second main board area 30, an opening connected to the first air passage is configured on the backboard 80, and the second air passage is configured under the backboard 80.

In the present embodiment, the second main board area 30 comprises a plurality of second sub-main boards which are longitudinally arranged, a guide plate 17 is slantly configured between the second main board area 30 and a lower wall of the case 10, and the guide plate 17 is connected to the plurality of second sub-main boards, so as to lead the air in the second air passage into the plurality of second sub-main boards.

A gap exists between the plurality of the first sub-main boards, the gap forms a part of the first air passage, and the first clapboard, the lower wall of the case 10 and the guide plate 17 form a part of the second air passage. The first air passage and the second air passage is isolated mutually and are not affected by each other, so as to avoid the heat accumulating between the first main board area 20 the second main board area 30.

In the present embodiment, the subrack further comprises: a first air exhaust device and a second air exhaust device 70, wherein:
the first air exhaust device is configured to drive the air entering from the first air inlet 20b into the first air passage to flow through the first main board area 20 and then exhaust from the rear wall 12 of the case 10, and the first air exhaust device is configured in the rear wall 12 of the case 10;
the second air exhaust device 70 is configured to drive the air entering from the second air inlet 30b into the second air passage to flow through the second main board area 30 and then exhaust from the rear wall 12 of the case 10, the second air exhaust device 70 is configured to the rear wall 12 of the case10, and the second air exhaust device 70 is configured to be isolated from the first air exhaust device.

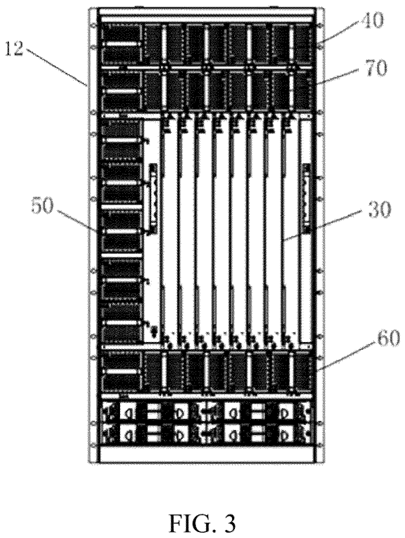

The first air exhaust device comprises a first sub-air exhaust device 40, a second sub-air exhaust device 50 and a third sub-air exhaust device 60 that are configured around the second main board area 30, the first sub-air exhaust device 40 and the third sub-air exhaust device 60 are respectively configured at the upside and underside of the second main board area 30, and the first sub-air exhaust device 40, the second sub-air exhaust device 50 and the third sub-air exhaust device 60 are connected together to form a C-type structure, as shown in FIG.3.

The first sub-air exhaust device 40, the second sub-air exhaust device 50 and the third sub-air exhaust device 60 which are presented in a C-type structure have stronger ability of heat dissipation and can implement much easier.

The first air exhaust device and the second air exhaust device are respectively configured at a first air outlet of the first air passage and a second air outlet of the second air passage.

The second air exhaust device 70 is configured between the second main board area 30 and the first sub-air exhaust device 40, and a second clapboard 18 is configured between the first sub-air exhaust device 40 and the second air exhaust device 70.

The first air inlet 20b is face to the first main board area 20, the cool air enters from the first air inlet 20b and goes through the first air hole 31 and the second air hole 32 on the plurality of first sub-main boards to cool the first sub-main boards in the first main board area 20, then the cool air that flows through the first main board area 20 goes through the opening on the backboard 80, and then exhausts the hot air from the first sub-air exhaust device 40, the second sub-air exhaust device 50 and the third sub-air exhaust device 60.

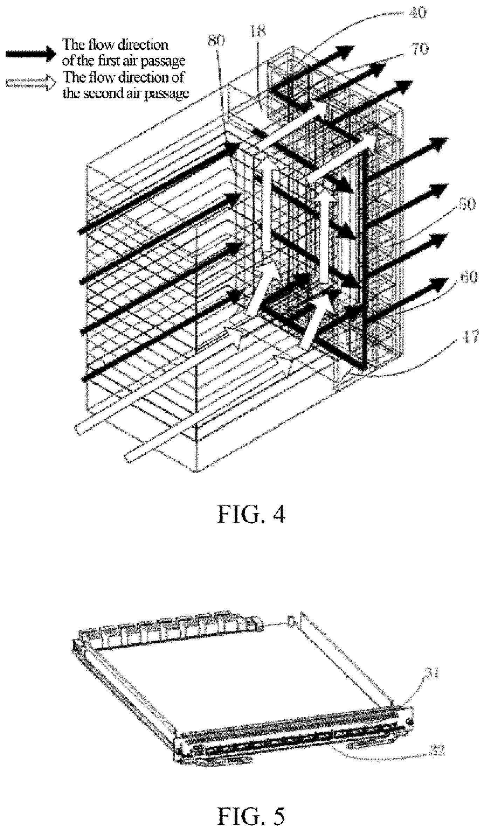

The second air inlet 30b is configured under the first main board area 20, the cool air enters from the second air inlet 30b, is leaded by the guide plate 17, and cools the plurality of second sub-main boards; after cooling the plurality of second sub-main boards, the hot air exhausts from the second air exhaust device 70. The air flow direction of the first air passage and the second air passage is shown in FIG.4, the black arrows represent the air flow direction of the first air passage, and the white arrows represent the air flow direction of the second air passage.

The subrack provided by the present invention uses a structure of the first air exhaust device, the second air exhaust device, and the first air passage and the second air passage to shorten the ventilation path and increase the effect of heat dissipation, which achieves the independent heat dissipation for the first main board area and the second main board area and avoids the heat interfering and accumulating mutually.

The embodiment of the present invention further provides a terminal comprising the above mentioned subrack.

The above mentioned description is the preferable embodiments of the present invention.

### Industrial Applicability

The present invention achieves independent heat dissipation for the first main board area and the second main board area, avoids the heat interfering and accumulating mutually, reduces the aging speed of the second main board at the rear of the subrack, and provides the reliability of the device.

## Claims

1. A subrack, comprising a case (10), a first main board area (20) configured at a front of the case (10), a second main board area (30) configured at a rear of the case (10), a first air passage, and a second air passage, wherein,
the first air passage, is configured within the case, a first air inlet (20b) of the first air passage is configured in a front wall of the case (10), and the first air inlet (20b) is configured opposite to the first main board area (20), and a first air outlet of the first air passage is configured in a rear wall of the case (10); and
a second air passage, is configured within the case (10), the second air passage is configured to be isolated from the first air passage, a second air inlet (30b) of the second air passage is configured in the front wall of the case (10), and a second air outlet of the second air passage is configured in the rear wall of the case (10),
wherein a first clapboard is configured between the first main board area (20) and the second air inlet (30b), and the first clapboard is used to isolate the first air inlet (20b) from the second air inlet (30b),
wherein the subrack further comprises a first air exhaust device, configured to drive air entering from the first air inlet (20b) into the first air passage to flow through the first main board area (20) and then exhaust from the rear wall of the case (10) and a second air exhaust device (70), configured to drive air entering from the second air inlet (30b) into the second air passage to flow through the second main board area (30) and then exhaust from the rear wall of the case, the second air exhaust device (70) being configured to be isolated from the first air exhaust device, **characterised in that**
the second air inlet (30b) is under the first main board area (20),
the first air exhaust device is configured in the rear wall of the case (10),
the second air exhaust device (70) is configured in the rear wall of the case (10),
the first air exhaust device and the second air exhaust device (70) are respectively configured at the first air outlet of the first air passage and the second air outlet of the second air passage, and **in that**
the first air exhaust device comprises a first sub-air exhaust device (40), a second sub-air exhaust device and a third sub-air exhaust device (60) that are configured about the second main board area (30), the first sub-air exhaust device (40) and the third sub-air exhaust device (60) are respectively configured at the upside and the underside of the second main board area (30) and the first sub-air exhaust device (40), the second sub-air exhaust device (50) and the third sub-air exhaust device (60) are connected together to form a C-type structure,
wherein the second air exhaust device (70) is configured between the second main board area (30) and the first sub-air exhaust device (40), and
a second clapboard is configured between the first sub-air exhaust device (40) and the second air exhaust device (70).

2. The subrack according to claim 1, wherein, the first main board area (20) comprises a plurality of first sub-main boards which are horizontally arranged, each of the first sub-main boards comprises a PCB board, a panel and a tray, a first air hole is configured at a part of the panel which is located on an upside of the PCB board, a second air hole is configured between the PCB board and the tray, both the first air hole and the second air hole are connected to the first air inlet, and the second air hole is connected to an adjacent first sub-main board through an open pore on the tray.

3. The subrack according to claim 1, wherein, a backboard is configured between the first main board area (20) and the second main board area (30), an opening connected to the first air passage is configured on the backboard, and the second air passage is configured under the backboard.

4. The subrack according to claim 3, wherein, the second main board area (30) comprises a plurality of second sub-main boards which are longitudinally arranged, a guide plate is slantly configured between the second main board area (30) and a lower wall of the case (10), and the guide plate is connected to the plurality of second sub-main boards to lead air in the second air passage into the plurality of second sub-main boards.

5. A terminal, comprising the subrack of any of claims 1 to 4.

## Patentansprüche

1. Baugruppenträger, umfassend ein Gehäuse (10), einen ersten Mainboard-Bereich (20), der an einer Vorderseite des Gehäuses (10) eingerichtet ist, einen zweiten Mainboard-Bereich (30), der an einer Hinterseite des Gehäuses (10) eingerichtet ist, einen ersten Luftkanal, und einen zweiten Luftkanal, wobei
der erste Luftkanal innerhalb des Gehäuses eingerichtet ist, ein erster Lufteinlass (20b) des ersten Luftkanals in einer vorderen Wand des Gehäuses (10) eingerichtet ist, und der erste Lufteinlass (20b) dem ersten Mainboard-Bereich (20) gegenüberliegend eingerichtet ist, und ein erster Luftauslass des ersten Luftkanals in einer hinteren Wand des Gehäuses (10) eingerichtet ist; und
ein zweiter Luftkanal innerhalb des Gehäuses (10) eingerichtet ist, der zweite Luftkanal so eingerichtet ist, dass er vom ersten Luftkanal isoliert ist, ein zweiter Lufteinlass (30b) des zweiten Luftkanals in der vorderen Wand des Gehäuses (10) eingerichtet ist, und ein zweiter Luftauslass des zweiten Luftkanals in der hinteren Wand des Gehäuses (10) eingerichtet ist,
wobei eine erste Schalungsplatte zwischen dem ersten Mainboard-Bereich (20) und dem zweiten Lufteinlass (30b) eingerichtet ist, und die erste Schalungsplatte dazu verwendet wird, den ersten Lufteinlass (20b) vom zweiten Lufteinlass (30b) zu isolieren,
wobei der Baugruppenträger weiter eine erste Luftabzugsvorrichtung umfasst, die dazu eingerichtet ist, vom ersten Lufteinlass (20b) eindringende Luft in den ersten Luftkanal zu treiben, sodass sie durch den ersten Mainboard-Bereich (20) strömt und dann aus der hinteren Wand des Gehäuses (10) abzieht, und eine zweite Luftabzugsvorrichtung (70), die dazu eingerichtet ist, vom zweiten Lufteinlass (30b) eindringende Luft in den zweiten Luftkanal zu treiben, sodass sie durch den zweiten Mainboard-Bereich (30) strömt und dann aus der hinteren Wand des Gehäuses abzieht, wobei die zweite Luftabzugsvorrichtung (70) so eingerichtet ist, dass sie von der ersten Luftabzugsvorrichtung isoliert ist, **dadurch gekennzeichnet, dass**
sich der zweite Lufteinlass (30b) unter dem ersten Mainboard-Bereich (20) befindet,
die erste Luftabzugsvorrichtung in der hinteren Wand des Gehäuses (10) eingerichtet ist,
die zweite Luftabzugsvorrichtung (70) in der hinteren Wand des Gehäuses (10) eingerichtet ist,
die erste Luftabzugsvorrichtung und die zweite Luftabzugsvorrichtung (70) jeweils am ersten Luftauslass des ersten Luftkanals und dem zweiten Luftauslass des zweiten Luftkanals eingerichtet sind, und dadurch, dass
die erste Luftabzugsvorrichtung eine erste Teil-Luftabzugsvorrichtung (40), eine zweite Teil-Luftabzugsvorrichtung und eine dritte Teil-Luftabzugsvorrichtung (60) umfasst, die um den zweiten Mainboard-Bereich (30) herum eingerichtet sind, wobei die erste Teil-Luftabzugsvorrichtung (40) und die dritte Teil-Luftabzugsvorrichtung (60) jeweils an der Oberseite und der Unterseite des zweiten Mainboard-Bereichs (30) eingerichtet sind, und die erste Teil-Luftabzugsvorrichtung (40), die zweite Teil-Luftabzugsvorrichtung (50) und die dritte Teil-Luftabzugsvorrichtung (60) so miteinander verbunden sind, dass sie eine Struktur vom C-Typ bilden,
wobei die zweite Luftabzugsvorrichtung (70) zwischen dem zweiten Mainboard-Bereich (30) und der ersten Teil-Luftabzugsvorrichtung (40) eingerichtet ist, und
eine zweite Schalungsplatte zwischen der ersten Teil-Luftabzugsvorrichtung (40) und der zweiten Luftabzugsvorrichtung (70) eingerichtet ist.

2. Baugruppenträger nach Anspruch 1, wobei der erste Mainboard-Bereich (20) eine Vielzahl von ersten Teil-Mainboards umfasst, die horizontal angeordnet sind, wobei jedes der ersten Teil-Mainboards eine Leiterplatte, eine Abdeckung und ein Fach umfasst, ein erstes Luftloch an einem Teil der Abdeckung eingerichtet ist, der sich an einer Oberseite der Leiterplatte befindet, ein zweites Luftloch zwischen der Leiterplatte und dem Fach eingerichtet ist, sowohl das erste Luftloch als auch das zweite Luftloch mit dem ersten Lufteinlass verbunden sind, und das zweite Luftloch durch eine offene Pore am Fach mit einem angrenzenden ersten Teil-Mainboard verbunden ist.

3. Baugruppenträger nach Anspruch 1, wobei eine Rückplatte zwischen dem ersten Mainboard-Bereich (20) und dem zweiten Mainboard-Bereich (30) eingerichtet ist, eine Öffnung, die mit dem ersten Luftkanal verbunden ist, an der Rückplatte eingerichtet ist, und der zweite Luftkanal unter der Rückplatte eingerichtet ist.

4. Baugruppenträger nach Anspruch 3, wobei der zweite Mainboard-Bereich (30) eine Vielzahl von zweiten Teil-Mainboards umfasst, die in Längsrichtung angeordnet sind, ein Leitblech schräg zwischen dem zweiten Mainboard-Bereich (30) und einer unteren Wand des Gehäuses (10) eingerichtet ist, und das Leitblech mit der Vielzahl von zweiten Teil-Mainboards verbunden ist, um Luft im zweiten Luftkanal in die Vielzahl von zweiten Teil-Mainboards zu lenken.

5. Endgerät, das den Baugruppenträger nach einem der Ansprüche 1 bis 4 umfasst.

## Revendications

1. Bac à cartes, comprenant un boîtier (10), une première zone de carte mère (20) configurée à l'avant du boîtier (10), une seconde zone de carte mère (30) configurée à l'arrière du boîtier (10), un premier passage d'air, et un second passage d'air, dans lequel,
le premier passage d'air est configuré dans le boîtier, une première entrée d'air (20b) du premier passage d'air est configurée dans une paroi avant du boîtier (10), et la première entrée d'air (20b) est configurée à l'opposé de la première zone de carte mère (20), et une première sortie d'air du premier passage d'air est configurée dans une paroi arrière du boîtier (10) ; et
un second passage d'air est configuré dans le boîtier (10), le second passage d'air est configuré pour être isolé vis-à-vis du premier passage d'air, une seconde entrée d'air (30b) du second passage d'air est configurée dans la paroi avant du boîtier (10), et une seconde sortie d'air du second passage d'air est configurée dans la paroi arrière du boîtier (10),
dans lequel un premier bardeau est configuré entre la première zone de carte mère (20) et la seconde entrée d'air (30b), et le premier bardeau est utilisé pour isoler la première entrée d'air (20b) vis-à-vis de la seconde entrée d'air (30b),
dans lequel le bac à cartes comprend en outre un premier dispositif d'échappement d'air, configuré pour entraîner de l'air entrant depuis la première entrée d'air (20b) dans le premier passage d'air à s'écouler à travers la première zone de carte mère (20) et à s'échapper ensuite de la paroi arrière du boîtier (10) et un second dispositif d'échappement d'air (70), configuré pour entraîner de l'air entrant depuis la seconde entrée d'air (30b) dans le second passage d'air à s'écouler à travers la seconde zone de carte mère (30) et à s'échapper ensuite de la paroi arrière du boîtier, le second dispositif d'échappement d'air (70) étant configuré pour être isolé vis-à-vis du premier dispositif d'échappement d'air, **caractérisé en ce que**
la seconde entrée d'air (30b) se trouve sous la première zone de carte mère (20), le premier dispositif d'échappement d'air est configuré dans la paroi arrière du boîtier (10),
le second dispositif d'échappement d'air (70) est configuré dans la paroi arrière du boîtier (10),
le premier dispositif d'échappement d'air et le second dispositif d'échappement d'air (70) sont respectivement configurés au niveau de la première sortie d'air du premier passage d'air et de la seconde sortie d'air du second passage d'air, et **en ce que**
le premier dispositif d'échappement d'air comprend un premier dispositif d'échappement d'air secondaire (40), un deuxième dispositif d'échappement d'air secondaire et un troisième dispositif d'échappement d'air secondaire (60) qui sont configurés autour de la seconde zone de carte mère (30), le premier dispositif d'échappement d'air secondaire (40) et le troisième dispositif d'échappement d'air secondaire (60) sont respectivement configurés au niveau du côté supérieur et du côté inférieur de la seconde zone de carte mère (30) et le premier dispositif d'échappement d'air secondaire (40), le deuxième dispositif d'échappement d'air secondaire (50) et le troisième dispositif d'échappement d'air secondaire (60) sont reliés ensemble pour former une structure de type C,
dans lequel le second dispositif d'échappement d'air (70) est configuré entre la seconde zone de carte mère (30) et le premier dispositif d'échappement d'air secondaire (40), et
un second bardeau est configuré entre le premier dispositif d'échappement d'air secondaire (40) et le second dispositif d'échappement d'air (70).

2. Bac à cartes selon la revendication 1, dans lequel, la première zone de carte mère (20) comprend une pluralité de premières cartes mères secondaires qui sont agencées horizontalement, chacune des premières cartes mères secondaires comprend une carte PCB, un panneau et un plateau, un premier trou d'air est configuré au niveau d'une partie du panneau qui se trouve sur un côté supérieur de la carte PCB, un second trou d'air est configuré entre la carte PCB et le plateau, le premier trou d'air et le second trou d'air sont tous deux connectés à la première entrée d'air, et le second trou d'air est connecté à une première carte mère secondaire adjacente par l'intermédiaire d'un pore ouvert sur le plateau.

3. Bac à cartes selon la revendication 1, dans lequel, un bardeau est configuré entre la première zone de carte mère (20) et la seconde zone de carte mère (30), une ouverture reliée au premier passage d'air est configurée sur le bardeau, et le second passage d'air est configuré sous le bardeau.

4. Bac à cartes selon la revendication 3, dans lequel, la seconde zone de carte mère (30) comprend une pluralité de secondes cartes mères secondaires qui sont agencées longitudinalement, une plaque de guidage est configurée de manière inclinée entre la seconde zone de carte mère (30) et une paroi inférieure du boîtier (10), et la plaque de guidage est connectée à la pluralité de secondes cartes mères secondaires pour amener de l'air situé dans le second passage d'air dans la pluralité de secondes cartes mères secondaires.

5. Terminal, comprenant le bac à cartes selon l'une quelconque des revendications 1 à 4.
